# EUROPEAN PATENT APPLICATION

(11) **EP 2 755 236 A2**
(43) Date of publication of application: **16.07.2014**
(21) Application number: 14150266.6
(22) Date of filing: 07.01.2014
(51) Int. Cl.: H01L 29/06, H01L 29/778, H01L 29/20

(54) **Semiconductor structure including a spatially confined dielectric region**

(30) Priority: 14.01.2013 US 201361752258 P; 24.12.2013 US 201314140222
(71) Applicant: International Rectifier Corporation, El Segundo, CA 90245 (US)
(72) Inventor: Briere, Michael A., Scottsdale, AZ Arizona 85266 (US)
(74) Representative: Dr. Weitzel & Partner

(57) **Abstract**

A semiconductor structure includes a III-Nitride field-effect transistor (FET) having a drain (234), a source (232), and a gate (236), fabricated over a substrate (210). A spatially confined dielectric region (240) is formed under the drain in the substrate, the spatially confined dielectric region reducing a capacitive coupling of the drain to the substrate. In another exemplary implementation, a spatially confined dielectric region is formed under each of the source and the drain of the FET, in the substrate, the spatially confined dielectric regions reducing a capacitive coupling of the source and the drain to the substrate.

## Description

### BACKGROUND

The present application claims the benefit of and priority to a provisional application entitled "III-Nitride Transistor Including Spatially Defined Buried Dielectric," Serial No. 61/752,258 filed on January 14, 2013. The disclosure in this pending provisional application is hereby incorporated fully by reference into the present application.

In addition, each of the following U.S. patents and patent applications is hereby incorporated by reference in its entirety into the present application:
U.S. Patent Number 6,649,287, entitled "Gallium Nitride Materials and Methods," issued on November 18, 2003;
U.S. Patent Number 7,892,938, entitled "Structure and Method for III-Nitride Monolithic Power IC," issued on February 22, 2011;
U.S. Patent Number 7,915,645, entitled "Monolithic Vertically Integrated Composite Group III-V and Group IV Semiconductor Device and Method for Fabricating Same," issued on March 29, 2011;
U.S. Patent Number 7,999,288, entitled "High Voltage Durability III-Nitride Semiconductor Device," issued on August 16, 2011;
U.S. Patent Number 8,159,003, entitled "III-Nitride Wafer and Devices Formed in a III-Nitride Wafer," issued on April 17, 2012;
U.S. Patent Application Number 13/197,514, entitled "High Voltage III-Nitride Transistor," filed on August 3, 2011;
U.S. Patent Application Number 13/197,676, entitled "High Voltage Durability III-Nitride HEMT," filed on August 3, 2011;
U.S. Patent Application Number 13/544,829, entitled "Composite Semiconductor Device With a SOI Substrate Having an Integrated Diode," filed on July 9, 2012; and
U.S. Patent Application Number 13/945,276, entitled "Integrated III-Nitride and Silicon Device," filed on July 18, 2013.

### I. DEFINITION

As used herein, the phrase "group III-V" refers to a compound semiconductor including at least one group III element and at least one group V element. By way of example, a group III-V semiconductor may take the form of a III-Nitride semiconductor. "III-Nitride", or "III-N", refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}AsₐP_{b}N_{(1-a-b)}), for example. III-Nitride also refers generally to any polarity including but not limited to Ga-polar, N-polar, semi-polar, or non-polar crystal orientations. A III-Nitride material may also include either the Wurtzitic, Zincblende, or mixed polytypes, and may include single-crystal, monocrystalline, polycrystalline, or amorphous structures. Gallium nitride or GaN, as used herein, refers to a III-Nitride compound semiconductor wherein the group III element or elements include some or a substantial amount of gallium, but may also include other group III elements in addition to gallium. A group III-V or a GaN transistor may also refer to a composite high voltage enhancement mode transistor that is formed by connecting the group III-V or the GaN transistor in cascode with a lower voltage group IV transistor.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates or silicon composite substrates such as silicon on insulator (SOI), separation by implantation of oxygen (SIMOX) process substrates, and silicon on sapphire (SOS), for example.

### II. BACKGROUND ART

Group III-V semiconductors, such as III-Nitride materials, are semiconductor compounds that have relatively wide direct bandgaps and can have strong piezoelectric polarizations, which can enable high breakdown fields, high saturation velocities, and the creation of two-dimensional electron gases (2DEGs). As a result, III-Nitride materials and other group III-V semiconductors are suitable for use in many microelectronic applications as field-effect transistors (FETs), including heterostructure FETs (HFETs) such as high electron mobility transistors (HEMTs).

Although the III-Nitrides are known as wide bandgap materials, they also have relatively high dielectric constants compared to silicon oxide (SiO₂). For example, gallium nitride (GaN) has a dielectric constant of approximately 9.5, and aluminum nitride (AlN) has a dielectric constant of approximately 9.1, compared to a dielectric constant of approximately 3.9 for SiO₂. As a result, when III-Nitride based FETs are employed for high voltage switching applications, the parasitic capacitance across the underlying III-Nitride material layers down to the device substrate can contribute to slower switching times and higher charge for a given voltage. Consequently, the increased parasitic capacitance between the drain or source of the FET and the FET substrate can have undesirable consequences for its high voltage switching performance.

In the conventional art, the various approaches developed to increase the breakdown voltage of III-Nitride devices by altering the source and drain regions in the substrate suffer from other performance drawbacks. One such technique uses locally etched backside substrate removal under the source and/or drain regions of the III-Nitride devices. Although this technique may increase the breakdown voltage of the device, it can adversely result in the formation of III-Nitride devices with both poor thermal characteristics and unstable surface conditions.

A second technique used is the formation of PN junctions in the substrate located under the drain region of the III-Nitride device. However this approach typically leads to leaky PN junctions, particularly at high temperatures, and may also result in relatively high substrate coupling capacitance. Thus, there remains a need for an alternative approach to forming III-Nitride power devices which exhibit fast switching times and reduced charge, while maintaining stable high voltage, high temperature performance, with reduced parasitic capacitance to the substrate.

### SUMMARY

The present disclosure is directed to a semiconductor structure including a spatially confined dielectric region, substantially as shown in and/or described in connection with at least one of the figures, and as set forth more completely in the claims.

### BRIEF DESCRIPTION OF THE DRAWINGS

Figure 1 shows a cross-sectional view of a conventional semiconductor structure.
Figure 2 shows a cross-sectional view of an exemplary semiconductor structure including a spatially confined dielectric region, according to one implementation.
Figure 3A shows a top view of an exemplary semiconductor structure including multiple spatially confined dielectric regions, according to one implementation.
Figure 3B shows a cross-sectional view of the exemplary semiconductor structure of Figure 3A.
Figure 4 shows a cross-sectional view of an exemplary semiconductor structure including multiple spatially confined dielectric regions, according to another implementation.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

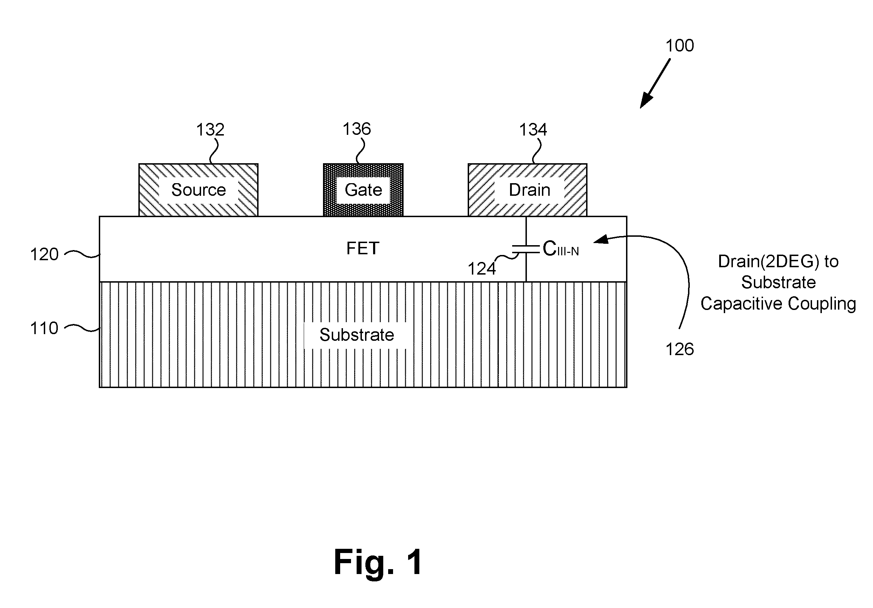

Figure 1 shows a cross-sectional view of conventional semiconductor structure 100. Semiconductor structure 100 includes field-effect transistor (FET) 120 fabricated over substrate 110. As shown in Figure 1, FET 120 includes source 132, drain 134, and gate 136. According to the example shown in Figure 1, FET 120 is implemented as a III-Nitride FET, such as a III-Nitride high electron mobility transistor (HFET) or other type of III-Nitride heterostructure FET (HFET) fabricated over substrate 110. Substrate 110 may be any type of substrate suitable for use as a support substrate for FET 120. Thus, substrate 110 may be a group IV substrate, such a silicon substrate for example.

As is the case for substantially all HFET structures, there are several paths for current flow and leakage across semiconductor structure 100. Figure 1 shows one such pathway due to the capacitive coupling of drain 134 to substrate 110 and labeled as parasitic coupling capacitor 124 (C_{III-N}). It is noted that although there may be additional parasitic capacitances associated with semiconductor structure 100, in many implementations, such as when source 132 is tied to substrate 124, the drain-to-substrate parasitic capacitance represented by parasitic coupling capacitor 124 is typically of special concern.

As stated above, although the III-Nitride materials are known as wide bandgap materials, they also have relatively high dielectric constants compared to silicon oxide (SiO₂). For example and as also noted above, gallium nitride (GaN) has a dielectric constant of approximately 9.5, and aluminum nitride (AlN) has a dielectric constant of approximately 9.1, which may be compared to a dielectric constant of approximately 3.9 for SiO₂. When III-Nitride based FETs are employed for high voltage switching applications, the parasitic capacitance across the underlying III-Nitride epitaxial layers of FET 120 down to substrate 110 and represented as parasitic coupling capacitor 124, contributes to slower switching times and higher switching charge for a given voltage. As a result, the drain-to-substrate capacitance represented by parasitic coupling capacitor 124 can have undesirable consequences for the high voltage switching (speed as well as charge) performance of FET 120.

One conventional method for reducing the parasitic capacitance represented by parasitic coupling capacitor 124 is to increase the thickness of the III-Nitride layers used in FET 120. However, in large scale manufacturing of semiconductor switches, large diameter substrates are typically employed. Moreover, the thickness of the III-Nitride layers formed on large diameter substrates is typically limited by the stresses produced in the III-Nitride material used to form FET 120, as well as in substrate 110.

The stresses produced in semiconductor structure 100 may be due to mismatch of the lattice constants and/or mismatch of the coefficients of thermal expansion between the III-Nitride layers used in FET 120 and the silicon or other typically non-native (i.e., non-III-Nitride) materials used to provide substrate 110. Those stresses can lead to excessive warp and bow of substrate 110, or to cracking of the III-N layers of FET 120. Consequently, there is a need for an alternative solution for reducing the parasitic capacitance represented by parasitic coupling capacitor 124 that does not require a substantial increase in the thickness of the III-Nitride layers used to form FET 120 for a given voltage rating. As noted above, the use of locally etched substrate regions or the formation of PN junctions in the substrate under the drain regions of the III-Nitride FET, as implemented in the conventional art, present other device performance limitations.

The present application is directed to semiconductor structures including FETs having reduced drain-to-substrate and/or reduced source-to-substrate capacitive coupling. The solutions disclosed by the present application provide FETs having improved high voltage switching performance and consequently improved standoff voltage capability, while concurrently providing adequate thermal transfer capability between the FET and the substrate. As disclosed herein, such solutions may be achieved through the use of one or more spatially confined dielectric regions formed in the substrate, under the FET drain and/or the FET source.

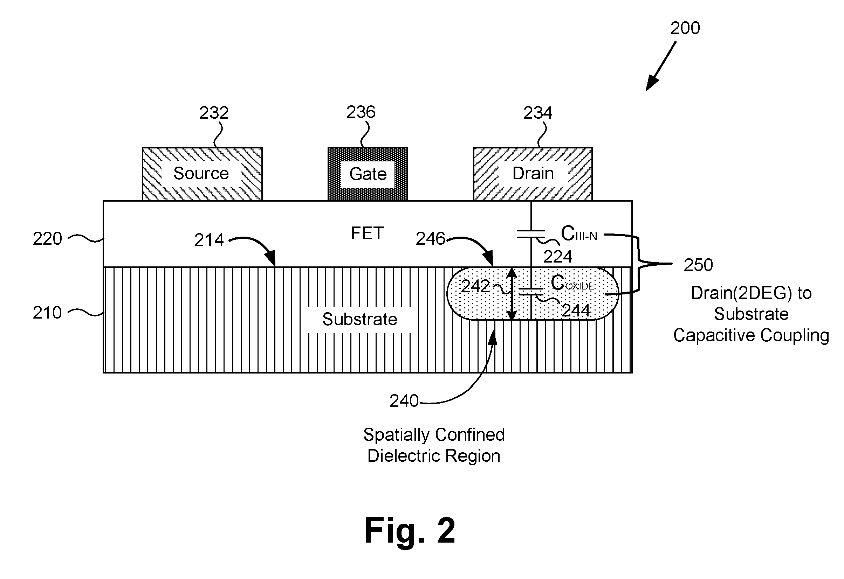

Referring to Figure 2, Figure 2 shows a cross-sectional view of exemplary semiconductor structure 200 including spatially confined dielectric region 240, according to one implementation. Semiconductor structure 200 includes FET 220 fabricated over substrate 210. As shown in Figure 2, FET 220 includes source 232, drain 234, and gate 236, and is fabricated over major surface 214 of substrate 210. According to the exemplary implementation shown in Figure 2, spatially confined dielectric region 240 is formed to a thickness 242 within substrate 210, under drain 234 of the FET 220. Also shown in Figure 2 are III-Nitride parasitic capacitor 224 and dielectric parasitic capacitor 244 contributing to the capacitive coupling of drain 234 to substrate 210 (i.e., drain-to-substrate capacitive coupling 250), as well as top side 246 of spatially confined dielectric region 240.

Substrate 210 may be formed using materials such as group IV materials (e.g., Si, SiC, Ge, SiGe, and the like), III-Nitride materials, sapphire, or other suitable material. Substrate 210 may be single crystal or polycrystalline, or may be formed as a composite substrate. Moreover, as used in the present application, "silicon substrate" may refer to any substrate that includes a silicon surface. Examples of suitable silicon substrates include substrates that are formed substantially entirely of silicon (e.g., bulk silicon wafers) and silicon-on-sapphire substrates (SOS) among others. Suitable silicon substrates also include composite substrates that have a silicon wafer bonded to another material such as diamond, AlN, or other polycrystalline materials. In some implementations, silicon substrates having different crystallographic orientations may be used. In some cases, for example, silicon (111) substrates may be preferred for substrate 210. In other cases, silicon (100) or (110) substrates may be preferred for substrate 210.

FET 220 may include multiple III-Nitride or other group III-V material layers. For example, FET 220 may include one or more III-Nitride transition layers and/or a buffer layer formed over substrate 210. In addition, FET 220 includes at least one active layer. In one implementation, for example, FET 220 may be a HEMT including a group III-V heterostructure formed over the transition and/or buffer layers formed over substrate 210. The group III-V heterostructure may include a group III-V barrier layer formed over a group III-V channel layer and giving rise to a 2DEG in the group III-V channel layer, as well as one or more capping and/or passivation layers formed over the group III-V barrier layer.

Spatially confined dielectric region 240 may be formed of SiO₂, for example, and may be formed in substrate 210 through oxygen implantation of substrate 210. For example, oxygen may be implanted into a silicon substrate at a concentration of approximately 1 x 10¹⁸/cm². There are several methodologies which may be used to form spatially confined dielectric region 240, including diffusion of oxygen, wafer bonding, and silicon lateral overgrowth techniques amongst others. However, in some implementations it may be advantageous or desirable to use separation by implantation of oxygen (SIMOX).

An SiO₂ spatially confined dielectric region 240 may be formed either prior to growth of the III-Nitride epitaxial layers of FET 220 over substrate 210, or may be substantially concurrently formed during the growth of those III-Nitride epitaxial layers. Thus, in some implementations, the elevated growth temperatures needed for formation of the III-Nitride epitaxial layers of FET 220 may be utilized to cause the silicon in the vicinity of the implanted oxygen to be consumed, thereby forming SiO₂ spatially confined dielectric region 240. For example, spatially confined dielectric region 240 may be located below major surface 214 of silicon substrate 210 such that there is a substantially uniform layer of silicon at major surface 214, as may be required for III-Nitride epitaxial nucleation. However, while the III-Nitride material of FET 220 is being deposited at high temperature, spatially confined dielectric region 240 may grow or expand towards major surface 214 of substrate 210 such that top side 246 of spatially confined dielectric region 240 interfaces with the III-Nitride material of FET 220.

As shown in Figure 2, in some implementations, spatially confined dielectric region 240 is substantially centered under drain 234. Moreover, spatially confined dielectric region 240 may by laterally confined in a plane substantially parallel to major surface 214 of substrate 210. Spatially confined dielectric region 240 may be a buried dielectric region within substrate 210, or may extend vertically within substrate 210 to major surface 214. In other words, in some implementations, all sides of spatially confined dielectric region 240 may be surrounded by substrate 210, while in other implementations, a top side of spatially confined dielectric region 240 may not be covered by substrate 210, as shown in Figure 2.

Although spatially confined dielectric region 240 can be formed of SiO₂, as described above, other dielectrics may also be used. For example, in silicon semiconductor manufacturing, low dielectric constant (low-κ) dielectrics have been utilized to reduce parasitic capacitance between various semiconductor layers. As used herein, a low-κ dielectric refers to a dielectric material having a dielectric constant lower than that of silicon SiO₂. As noted above, the dielectric constant of SiO₂ is approximately 3.9. Thus, low-κ dielectrics, such as carbon doped or fluorine doped SiO₂, among other low-κ dielectrics, can be used to form spatially confined dielectric region 240.

Thickness 242 of spatially confined dielectric region 240 depends partly on the voltage range of FET 220. For example, to hold off approximately one thousand volts (1,000 V), thickness 242 of a SiO₂ spatially confined dielectric region 240 would be approximately one micrometer (1.0 µm). In various implementations, thickness 242 of spatially confined dielectric region 240 may be in a range from approximately 0.1 µm to approximately 3.0 µm.

As further shown in Figure 2, formation of spatially confined dielectric region 240 results in an equivalent circuit in which III-Nitride parasitic capacitor 224 and dielectric parasitic capacitor 244 are coupled in series between drain 234 of FET 220 and substrate 210. According to the present exemplary implementation, the addition of dielectric parasitic capacitor 244 in series with III-Nitride parasitic capacitor 224 advantageously reduces overall drain-to-substrate capacitive coupling 250 for a given voltage. As a result, the presence of spatially confined dielectric region 240 in substrate 210, and under drain 234 of FET 220, improves the switching time and charge performance of FET 220.

It is noted that although the exemplary implementation shown in Figure 2 depicts spatially confined dielectric region 240 as being formed under drain 234 of FET 220, in other implementations spatially confined dielectric region 240 may be formed under source 232 of FET 220, or under both drain 234 and source 232 of FET 220. In implementations in which spatially confined dielectric region 240 is formed in substrate 210 under source 232, spatially confined dielectric region 240 reduces a capacitive coupling of source 232 to substrate 210. Moreover, in implementations in which spatially confined dielectric region 240 is formed in substrate 210 under both drain 234 and source 232, spatially confined dielectric regions 240 reduces a capacitive coupling of both drain 234 and source 232 to substrate 210.

It is further noted that although spatially confined dielectric region 240 need not be formed so as only to underlie drain 234 and/or source 232 of FET 220, those implementations confer advantages with regard to dissipation of heat produced by FET 220. The presence of a buried dielectric material in substrate 210 can have the undesired consequence of obstructing the thermal path between FET 220, where heat is generated, and the bottom of substrate 210, where heat is typically extracted. Consequently, use of spatially confined dielectric region 240, rather than a continuous dielectric layer, enables the advantages resulting from reduction of the capacitive coupling of drain 234 and/or source 232 to substrate 210 described above, while concurrently enabling the use of conventional thermal management techniques to provide efficient heat management for FET 220.

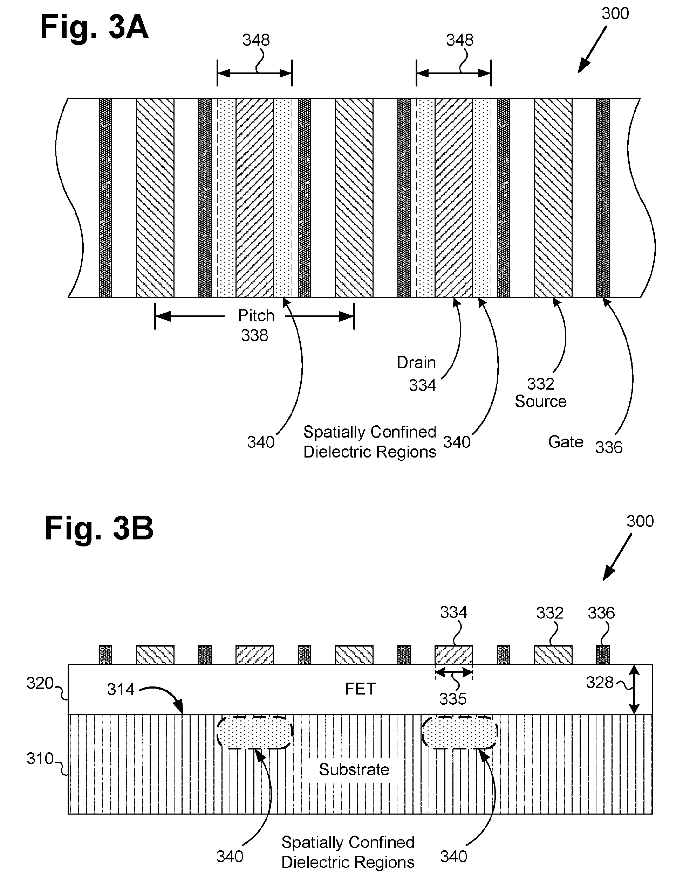

Continuing to Figures 3A and 3B, Figure 3A shows a top view of exemplary semiconductor structure 300 including multiple spatially confined dielectric regions 340, while Figure 3B shows a cross-sectional view of exemplary semiconductor structure 300. As shown in 3B, semiconductor structure 300 includes FET 320 fabricated over substrate 310. As shown in Figures 3A and 3B, FET 320 includes source regions 332, drain regions 334, and gates 336, and is fabricated over major surface 314 of substrate 310. Also shown in Figure 3 is width 348 of spatially confined dielectric regions 340, and pitch 338 of FET 320, i.e., the distance between the centers of immediately adjacent, or neighboring, source regions 332. In addition, the width of a drain contact of FET 320 is conceptually represented by interval 335, and the thickness of the III-Nitride or other group III-V material layers used to produce FET 320 is represented as thickness 328, in Figure 3B.

Although not shown in Figures 3A and 3B in the interests of conceptual clarity, it is noted that semiconductor structure 300 may include additional overlying layers including passivation and insulating layers, field plates (source, gate, and drain), as well as metal bond pads, traces, and interconnect vias. As shown in Figures 3A and 3B spatially confined dielectric regions 340 are centered under respective drain regions 334 and extend laterally toward gates 336 in both directions. FET 320 including source regions 332, drain regions 334, and gates 336 corresponds in general to FET 220 including source 232, drain 234, and gate 236, in Figure 2. Moreover, substrate 310 and spatially confined dielectric regions 340, in Figures 3A and 3B, correspond respectively to substrate 210 and spatially confined dielectric region 240, in Figure 2, and may share any of the characteristics attributed to those corresponding features above.

It is noted that in some implementations, it may be advantageous or desirable to determine width 348 of spatially confined dielectric regions 340 based on pitch 338 of FET 320. For example, in one implementation, it may be advantageous or desirable to restrict width 348 to less then approximately one half (0.5) times pitch 338 of FET 320. In other implementations, it may be advantageous or desirable to determine width 348 of spatially confined dielectric regions 340 based on thickness 328 of the III-Nitride or other group III-V layer used to form FET 320, as well as on interval 335 corresponding to the width of the drain contacts formed on FET 320. For example, it may be advantageous or desirable to restrict width 348 of spatially confined dielectric regions 340 to less than approximately one or two times thickness 328, plus interval 335. As a specific example, in various implementations, width 348 of spatially confined dielectric regions 340 may lie in a range from approximately 5 µm to approximately 30 µm.

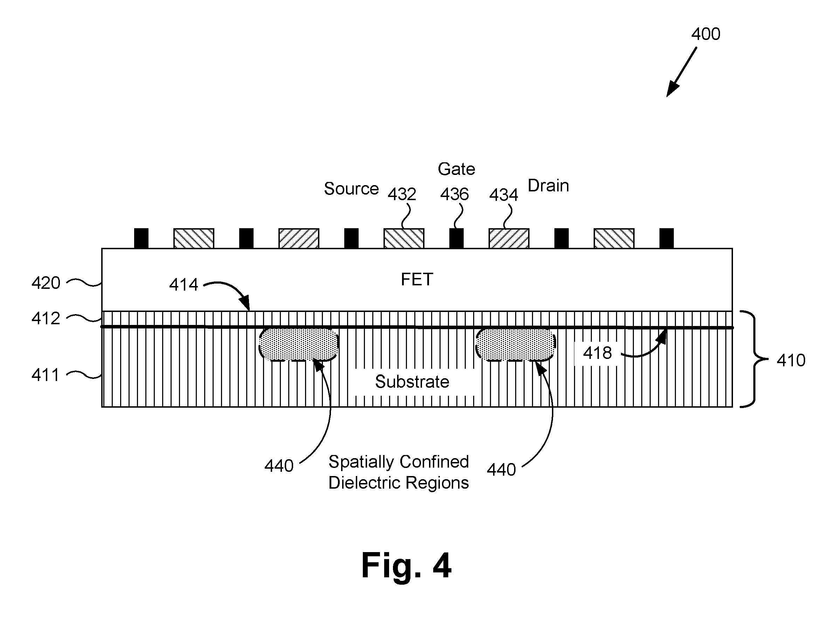

Moving to Figure 4, Figure 4 shows a cross-sectional view of exemplary semiconductor structure 400 including multiple spatially confined dielectric regions 440, according to another implementation. Semiconductor structure 400 includes FET 420 fabricated over composite substrate 410. As shown in Figure 4, FET 420 includes source regions 432, drain regions 434, and gates 436, and is fabricated over major surface 414 of composite substrate 410. As further shown in Figure 4, composite substrate 410 includes first substrate layer 411 having spatially confined dielectric regions 440 formed therein, and second substrate layer 412 formed over first substrate layer 411 and under FET 420. FET 420 including source regions 432, drain regions 434, and gates 436 corresponds in general to FET 220 including source 232, drain 234, and gate 236, in Figure 2. Moreover, spatially confined dielectric regions 440, in Figure 4, correspond to spatially confined dielectric region 240, in Figure 2, and may share any of the characteristics attributed to that corresponding feature above.

Spatially confined dielectric islands or regions 440 may be formed at top surface 418 of first substrate layer 411 of composite substrate 410. Silicon epitaxy with lateral overgrowth may then be used to re-grow silicon on second substrate layer 412 between and above spatially confined dielectric regions 440 and top surface 418 of first substrate layer 411, followed by planarization using standard chemical mechanical polishing (CMP) techniques at a top surface of second substrate layer 412 to provide major surface 414 of composite substrate 410. In some implementations, a thin final epitaxial layer of silicon may be grown over the CMP surface to form major surface 414 of composite substrate 410 as a III-Nitride ready surface. As a result, and as shown in Figure 4, in some implementations, all sides of spatially confined dielectric regions 440 may be surrounded by composite substrate 410.

In addition to improving the coupling capacitance of the FET drain and/or source to the substrate, the spatially confined dielectric regions disclosed in the present application can improve the standoff voltage capability of a FET for a given III-Nitride epitaxial layer thickness. Such a performance improvement results form the fact that some portion of the high field regions fall across the spatially confined dielectric regions, which have higher breakdown capability than the silicon substrate itself. This has the additional benefit of a reduction in the thickness of the III-Nitride epitaxial layer required in FET 220 to support a given standoff voltage. Because the present concepts permit use of thinner III-Nitride layers to support a given standoff voltage, those concepts further enable use of larger diameter wafers for fabrication of FET 220, and/or increased epitaxial throughput.

Thus the present application discloses semiconductor structures including FETs having reduced drain-to-substrate and/or reduced source-to-substrate capacitive coupling. As a result, the solutions disclosed by the present application provide FETs having improved standoff voltage capability and improved high voltage switching performance, while concurrently providing adequate thermal transfer capability between the FET and the substrate. As explained above, the presently disclosed solutions are enabled by formation of one or more spatially confined dielectric regions in the substrate, under the FET drain and/or the FET source.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the spirit and the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A semiconductor structure comprising:
a III-Nitride field-effect transistor (FET) including a drain, a source, and a gate, fabricated over a substrate;
a spatially confined dielectric region formed under said drain in said substrate;
said spatially confined dielectric region reducing a capacitive coupling of said drain to said substrate.

2. The semiconductor structure of claim 1, wherein said spatially confined dielectric region is substantially centered under said drain.

3. The semiconductor structure of claim 1, wherein said spatially confined dielectric region comprises silicon oxide.

4. The semiconductor structure of claim 1, wherein said substrate comprises a group IV semiconductor substrate.

5. The semiconductor structure of claim 1, wherein said substrate is one of a silicon substrate and a composite silicon substrate.

6. The semiconductor structure of claim 1, wherein said III-Nitride FET comprises a III-Nitride high electron mobility transistor (HEMT).

7. A semiconductor structure comprising:
a III-Nitride field-effect transistor (FET) including a drain, a source, and a gate, fabricated over a substrate;
a spatially confined dielectric region formed under each of said source and said drain in said substrate;
said spatially confined dielectric region reducing a capacitive coupling of said source and said drain to said substrate.

8. The semiconductor structure of claim 7, wherein all sides of said spatially confined dielectric region are surrounded by said substrate.

9. The semiconductor structure of claim 7, wherein a top side of said spatially confined dielectric region is not covered by said substrate.

10. A method comprising:
forming a spatially confined dielectric region in a substrate;
fabricating a III-Nitride field-effect transistor (FET) over said substrate, said III-Nitride FET including a drain, a source, and a gate;
said drain of said III-Nitride FET being formed over said spatially confined dielectric region so as to reduce a capacitive coupling of said drain to said substrate.

11. The method of claim 10, wherein said spatially confined dielectric region is formed through oxygen implantation of said substrate.

12. The method of claim 10, further comprising forming a silicon lateral epitaxial overgrowth layer above said spatially confined dielectric region and below said III-Nitride FET.

13. The method of claim 10, wherein said spatially confined dielectric region is substantially centered under said drain.

14. The method of claim 10, wherein said substrate comprises a group IV semiconductor substrate.

15. The method of claim 10, wherein said substrate is one of a silicon substrate and a composite silicon substrate.
